# EUROPÄISCHE PATENTANMELDUNG

(11) **EP 2 043 105 A1**
(43) Veröffentlichungstag der Anmeldung: **01.04.2009**
(21) Anmeldenummer: 07018978.2
(22) Anmeldetag: 26.09.2007
(51) Int. Cl.: G11C 16/10, G11C 29/00

(54) **Kopierverfahren für NAND-Flash-Speicher**

(71) Anmelder: SIEMENS AKTIENGESELLSCHAFT, 80333 München (DE)
(72) Erfinder: Renn, Harald, 90408 Nürnberg (DE)

(57) **Zusammenfassung**

Die Erfindung betrifft ein Verfahren zur Durchführung eines Kopierervorgangs in einem NAND-Flash-Speicher (1), wobei Daten (D01-D2n) im Speicher (1) in Sektoren (S1-Sn) abgelegt werden, die zu Blöcken (B0-B2,EB0-EB2) gruppiert sind, von denen eine vorgebbare Anzahl als Ersatzblöcke (EB0-EB2) bereitgehalten werden, und wobei bei Vorliegen eines Defektes in einem Block (B0-B2,EB0-EB2) alle Daten des betreffenden Blocks (B0-B2,EB0-EB2) kopiert werden. Um die in einem Fehlerfall maximal notwendige Kapazität der Energiespeicherung zu reduzieren, wird ein Verfahren der eingangs genannten Art vorgeschlagen, bei dem
- ein Auftrag (A1,A2) zur Durchführung des Kopierervorgangs erstellt wird, der den fehlerhaften Block (B0-B2,EB0-EB2) bezeichnet, dessen Daten (D01-D2n) zu kopieren sind,
- der Auftrag (A1,A2) in einem ersten Sektor (S1) eines ersten Ersatzblockes (EB0,EB2) gespeichert wird,
- ein Status (St1,St2) des Kopierervorgangs in einer Spare-Area dieses Sektors gespeichert wird,
- die Daten (D01-D2n) in die folgenden Sektoren des ersten Ersatzblockes (EB0) und einen weiteren Sektor eines zweiten Ersatzblockes (EB1) kopiert werden und
- in einer Einschaltphase einer Energieversorgung des Speichers anhand des Status überprüft wird, ob der Auftrag beendet wurde, und bei nicht-beendetem Auftrag der Kopiervorgang fortgesetzt wird.

## Beschreibung

Die Erfindung betrifft ein Verfahren zur Durchführung eines Kopierervorgangs in einem NAND-Flash-Speicher, wobei Daten im Speicher in Sektoren abgelegt werden, die zu Blöcken gruppiert sind, von denen eine vorgebbare Anzahl als Ersatzblöcke bereitgehalten werden, und wobei bei Vorliegen eines Defektes in einem Block alle Daten des betreffenden Blocks kopiert werden. Die Erfindung betrifft weiter einen entsprechenden NAND-Flash-Speicher.

Ein derartiges Verfahren kommt insbesondere in Systemen zum Einsatz, bei denen sicherzustellen ist, dass auch im Falle eines Ausfalls einer Energieversorgung des NAND-Flash-Speichers ein begonnener Kopiervorgang korrekt abgeschlossen wird. Dies betrifft z.B. Steuerungen in der Automatisierungstechnik, bei denen die Remanenzsicherung im Ausschaltfall (Netz-Aus) kritisch ist. Es gibt Daten, die einem Benutzer nach dem nächsten Einschalten (Netz-Ein) wieder korrekt zur Verfügung stehen müssen. Für diese Speicherung wird oft ein so genannter NAND-Flash-Speicher verwendet.

Dieser Speichertyp hat eine Besonderheit: Es dürfen bei ihm Fehler auftreten (hier muss ein ECC-Code verwendet werden), und es können Blöcke beim Beschreiben oder Löschen ausfallen, so dass sie nicht mehr verwendet werden dürfen. In diesem Fall muss der Inhalt (der Sektoren des betreffenden Blockes) in freie, d.h. vom System bereits vorgehaltene, Blöcke kopiert werden.

Dieser Vorgang dauert entsprechend der Anzahl der Sektoren, die zu übertragen sind, und wenn ein Fehlerfall in bzw. kurz vor einem Netz-Aus auftritt, muss noch entsprechend lange Energie zur Verfügung stehen, bis der Vorgang abgeschlossen ist. Diese Versorgungsdauer führt dazu - wenn beispielsweise keine Batteriepufferung vorhanden ist -, dass große und somit teure Stützkondensatoren notwendig sind, um die Energie zwischenzuspeichern, die benötigt wird, um einen kompletten Block umzukopieren. Denn da man nie weiß, wann der Fehlerfall eintritt, muss die Energiepufferung für diesen Maximalfall ausgelegt werden. Das heißt das Problem wird bislang so gelöst, dass genügend große Kondensatoren eingesetzt werden, um die maximal notwendige Energie - d.h. die Zeit, um einen kompletten Block zu kopieren - zur Verfügung zu haben, die im Netz-Aus benötigt wird, um auch im Fehlerfall ein korrektes Abspeichern der Daten zu ermöglichen.

Ein NAND-Flash-Speicher ist wie folgt aufgebaut: Er besitzt eine Anzahl von Blöcken, die wiederum in eine Anzahl von. Sektoren unterteilt sind. Beschreiben lassen sich die Sektoren einzeln, d.h. die Daten können von 1 nach 0 programmiert werden, aber nicht anders herum. Um nun wieder eine 1 in einer Speicherzelle des Sektors zu erzeugen, d.h. um ihn neu programmieren zu können, muss ein ganzer Block gelöscht werden. Zusätzlich gibt es noch für jeden Sektor eine so genannte Spare-Area, in der Verwaltungsdaten abgelegt werden können.

Ferner braucht man bei einem NAND-Flash-Speicher immer Ersatzblöcke, da beim Programmieren oder Löschen Defekte auftreten können und dieser Block dann nicht mehr programmiert oder gelöscht werden darf. Somit muss eine gewisse Anzahl von Blöcken zur Fehlerbehandlung vorhanden sein; in der Regel werden 10% der verwendeten Blöcke als Ersatzblöcke vorgehalten. Tritt in einer kritischen Phase ein Fehler auf - wie z.B. in einer Netz-Aus-Phase - so muss eine Energiespeicherung genügend Energie zur Verfügung stellen, damit alle Sektoren in einem Block komplett in den Ersatzblock kopiert werden können.

Aus der DE 60 2004 002 947 T2 ist ein NAND-Flash-Speicher bekannt, bei dem ein fehlerhafter Speicherblock nicht weiter benutzt werden darf und entsprechend markiert wird, während einer der Ersatzblöcke anstelle dessen verwendet wird.

Der Erfindung liegt die Aufgabe zugrunde, ein Kopierverfahren für einen NAND-Flash-Speicher anzugeben, durch das die in einem Fehlerfall maximal notwendige Kapazität der Energiespeicherung reduziert wird.

Der Erfindung liegt ferner die Aufgabe zugrunde, einen NAND-Flash-Speicher mit einer Energiespeicherung mit einer für einen Fehlerfall maximal notwendigen reduzierten Kapazität anzugeben.

Diese Aufgabe wird durch ein Verfahren der eingangs genannten Art dadurch gelöst, dass
- ein Auftrag zur Durchführung des Kopierervorgangs erstellt wird, der den fehlerhaften Block bezeichnet, dessen Daten zu kopieren sind,
- der Auftrag in einem ersten Sektor eines ersten Ersatzblockes gespeichert wird,
- ein Status des Kopierervorgangs in einer Spare-Area dieses Sektors gespeichert wird,
- die Daten in die folgenden Sektoren des ersten Ersatzblockes und einen weiteren Sektor eines zweiten Ersatzblockes kopiert werden und
- in einer Einschaltphase einer Energieversorgung des Speichers anhand des Status überprüft wird, ob der Auftrag beendet wurde, und bei nicht-beendetem Auftrag der Kopiervorgang fortgesetzt wird.

Die Aufgabe wird ferner durch einen NAND-Flash-Speicher mit den in Anspruch 3 angegebenen Merkmalen gelöst.

Durch das Erstellen eines Auftrags zur Durchführung des Kopierervorgangs, der als erstes - d.h. noch vor den Daten - gespeichert wird, ist sichergestellt, dass selbst im Falle eines Netz-Aus die Information über noch zu kopierende Daten nicht verloren geht. Es ist dabei nicht notwendig, soviel Energie mittels einer Energiespeicherung zur Verfügung zu stellen, dass im Falle eines Wegfalls der Stromversorgung noch ein kompletter Block kopiert werden kann. Stattdessen wird in einer Einschaltphase der Stromversorgung überprüft, ob noch Aufträge anstehen, die durch den Netz-Aus nicht beendet werden konnten und nun ggf. fortgesetzt werden müssen. In dieser Phase ist das System noch nicht hochgelaufen und über dem Versorgungsnetz steht genügend Energie zur Verfügung, um den Auftrag zu Ende zu führen. Auf diese Weise stehen die Daten nach dem Einschalten - d.h. wenn das System komplett wieder hochgefahren ist - korrekt zur Verfügung.

Das erfindungsgemäße Verfahren hat zur Folge, dass sich die Anzahl der benötigten Sektoren in den Ersatzblöcken im Vergleich zu einer 1:1-Zuordnung von jeweiligem Ersatzblock zu fehlerhaftem Block um Eins erhöht, das heißt für einen fehlerhaften Block muss noch ein zusätzlicher Sektor eines weiteren Ersatzblockes verwendet werden, da der Auftrag zur Durchführung des entsprechenden Kopierervorgangs bereits im ersten Sektor des ersten Ersatzblockes gespeichert wurde. Erst wenn die Anzahl der fehlerhaften Blöcke die Sektoranzahl eines Blocks übersteigt, muss ein weiterer Ersatzblock hinzugenommen werden.

Dafür benötigt der NAND-Flash-Speicher durch das erfindungsgemäße Verfahren in der kritischen Phase von der Energiespeicherung nur die Energie, die benötigt wird, um zwei Sektoren zu schreiben (den Auftrag zur Durchführung des Kopierervorgangs sowie die Markierung des fehlerhaften Blocks). Die Kennung, was in der nächsten Netz-Ein-Phase noch zu machen ist, wird in der Spare-Area des Sektors als spezielle Kennung abgelegt.

In einer vorteilhaften Form der Ausgestaltung wird eine Zugehörigkeit zwischen einer logischen und einer physikalischen Speicheradresse in einer Spare-Area eines jeden Sektors gespeichert. Ein Anwender greift auf den NAND-Flash-Speicher immer logisch zu, d.h. das erfindungsgemäße Verfahren wird in den Treiber des Speichers integriert, der eine Umsetzung von logischen auf physikalische Adressen vornimmt. Für diesen Zweck gibt es zwei Möglichkeiten: Entweder man speichert die logisch/physikalischen Umsetzungsdaten in einem eigenen Block, oder man wählt - wie bei diesem Ausführungsbeispiel - einen Eintrag in jeder Spare-Area eines Sektors. Da die Zugehörigkeit in jeder Spare-Area eines Sektors abgelegt wird und es keine Listenverkettung fest in Blöcken gibt, lässt sich das erfindungsgemäße Verfahren auf diese Weise besonders gut und einfach umsetzen.

Im Folgenden wird die Erfindung anhand der in den Figuren dargestellten Ausführungsbeispiele näher beschrieben und erläutert. Es zeigen:
- FIG 1: eine schematische Darstellung eines NAND-Flash-Speichers nach einem ersten Fehlerfall,
- FIG 2: den Speicher aus FIG 1 nach einem zweiten Fehlerfall.

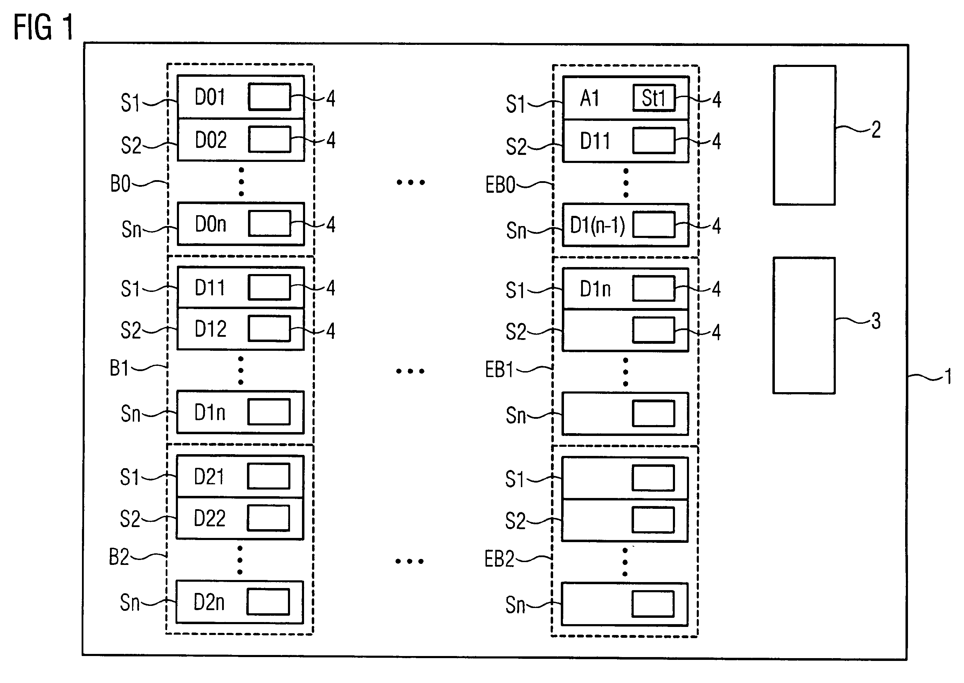

Fig 1 zeigt einen NAND-Flash-Speicher 1 mit einer Energiespeicherung 2 und einem Treiber 3 sowie Blöcken B0-B2, EB0-EB2 zur Speicherung von Daten D01-D2n, wobei jeder Block B0-B2, EB0-EB2 in Sektoren S1-Sn unterteilt ist. Dabei weist jeder Sektor S1-Sn eine Spare-Area 4 auf, in der Verwaltungsdaten wie beispielsweise die Zuordnung von logischen zu physikalischen Adressen abgelegt werden. Von den Blöcken B0-B2, EB0-EB2 ist eine vorgebbare Anzahl als Ersatzblöcke EB0-EB2 vorgesehen, um im Falle eines Defektes in einem der Blöcke B0-B2 die Daten D01-D2n des betroffenen Blockes aufzunehmen.

Im in der Figur gezeigten Beispiel ist ein Defekt im Block B1 aufgetreten, so dass die Daten D11-D1n kopiert werden müssen und der Block B1 durch einen Eintrag in der Spare-Area 4 als fehlerhaft markiert wird. Zur Durchführung des Kopierervorgangs wird ein Auftrag A1 erstellt und in einem ersten Sektor S1 eines ersten Ersatzblockes EB0 gespeichert. In den folgenden Sektoren S2-Sn werden nun die Daten D11-D1(n-1) gespeichert sowie im ersten Sektor S1 des zweiten Ersatzblockes EB1 die Daten D1n, da aufgrund der Speicherung des Auftrags A1 ein weiterer Sektor erforderlich ist. Dabei wird der Status St1 des Kopierervorgangs in der Spare-Area 4 des den Auftrag A1 enthaltenden Sektors S1 im Ersatzblock EB0 festgehalten.

Hiermit ist der Vorteil verbunden, dass im Fehlerfalle bei Auftreten eines Netz-Aus nicht mehr soviel Energie von der Energiespeicherung 2 zur Verfügung gestellt werden muss, dass die Daten D11-D1n des kompletten Blockes B1 noch kopiert werden können. In einem derartigen Fall wird in der nächsten Netz-Ein-Phase überprüft, ob der Auftrag A1 beendet wurde, und ggf. der Kopiervorgang an der dem Status St1 entsprechenden Stelle fortgesetzt. Somit wird die benötigte Kapazität der Energiespeicherung 2 (beispielsweise Stützkondensatoren) erheblich reduziert, was ebenso zu einer Reduzierung der Kosten führt.

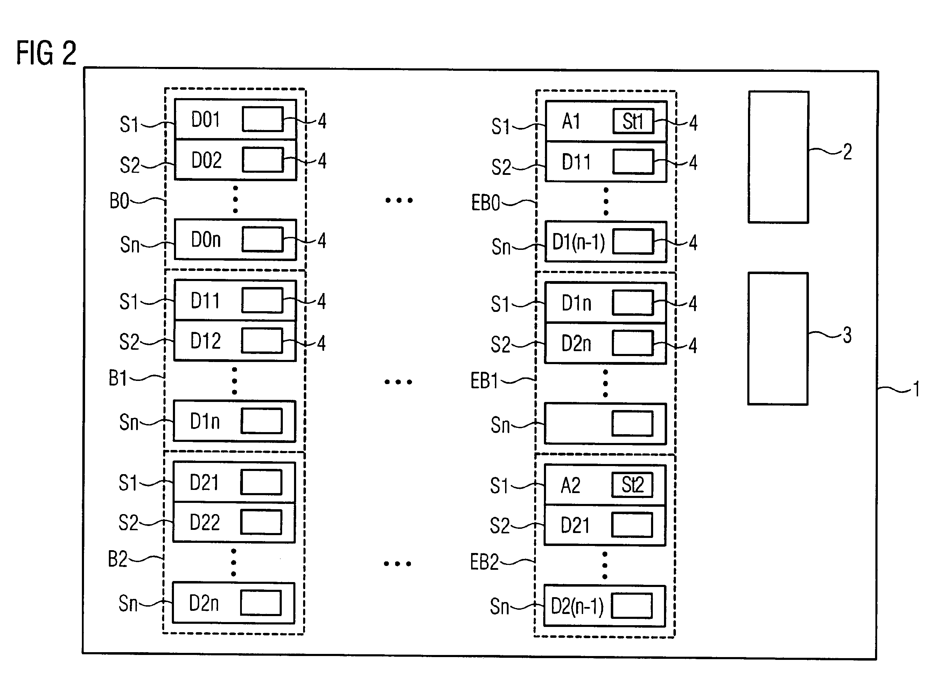

Fig. 2 zeigt den NAND-Flash-Speicher 1 aus Fig. 1 nach Auftreten eines erneuten Fehlers im Block B2. Zur Durchführung des erneuten Kopierervorgangs wird wiederum ein Auftrag A2 erstellt und in einem ersten Sektor S1 des Ersatzblockes EB2 gespeichert. Im folgenden werden die Daten D21-D2(n-1) in die verbleibenden Sektoren S2-Sn des Ersatzblockes EB2 und die Daten D2n in den Sektor S2 von Ersatzblock EB1 kopiert. Das erfindungsgemäße Kopierverfahren füllt also zunächst die noch freien Sektoren des erst teilweise benutzten Ersatzblockes EB1 auf, so dass erst nach vollständiger Auffüllung ein weiterer zusätzlicher Ersatzblock (im Vergleich zu einer 1:1-Zuordnung von jeweils fehlerhaftem Block zu Ersatzblock) benötigt wird.

Für eine Erläuterung der weiteren Bezugszeichen wird auf das zur Figur 1 Gesagte verwiesen.

Zusammenfassend betrifft die Erfindung ein Verfahren zur Durchführung eines Kopierervorgangs in einem NAND-Flash-Speicher, wobei Daten im Speicher in Sektoren abgelegt werden, die zu Blöcken gruppiert sind, von denen eine vorgebbare Anzahl als Ersatzblöcke bereitgehalten werden, und wobei bei Vorliegen eines Defektes in einem Block alle Daten des betreffenden Blocks kopiert werden. Um die in einem Fehlerfall maximal notwendige Kapazität der Energiespeicherung zu reduzieren, wird ein Verfahren der eingangs genannten Art vorgeschlagen, bei dem
- ein Auftrag zur Durchführung des Kopierervorgangs erstellt wird, der den fehlerhaften Block bezeichnet, dessen Daten zu kopieren sind,
- der Auftrag in einem ersten Sektor eines ersten Ersatzblockes gespeichert wird,
- ein Status des Kopierervorgangs in einer Spare-Area dieses Sektors gespeichert wird,
- die Daten in die folgenden Sektoren des ersten Ersatzblockes und einen weiteren Sektor eines zweiten Ersatzblockes kopiert werden und
- in einer Einschaltphase einer Energieversorgung des Speichers anhand des Status überprüft wird, ob der Auftrag beendet wurde, und bei nicht-beendetem Auftrag der Kopiervorgang fortgesetzt wird.

## Patentansprüche

1. Verfahren zur Durchführung eines Kopierervorgangs in einem NAND-Flash-Speicher (1), wobei Daten (D01-D2n) im Speicher (1) in Sektoren (S1-Sn) abgelegt werden, die zu Blöcken (B0-B2, EB0-EB2) gruppiert sind, von denen eine vorgebbare Anzahl als Ersatzblöcke (EB0-EB2) bereitgehalten werden, und wobei bei Vorliegen eines Defektes in einem Block (B0-B2, EB0-EB2) alle Daten (D01-D2n) des betreffenden Blocks (B0-B2, EB0-EB2) kopiert werden,
**dadurch gekennzeichnet, dass**
- ein Auftrag (A1, A2) zur Durchführung des Kopierervorgangs erstellt wird, der den fehlerhaften Block (B0-B2, EB0-EB2) bezeichnet, dessen Daten (D01-D2n) zu kopieren sind,
- der Auftrag (A1, A2) in einem ersten Sektor (S1) eines ersten Ersatzblockes (EB0, EB2) gespeichert wird,
- ein Status (St1, St2) des Kopierervorgangs in einer Spare-Area (4) dieses Sektors (S1) gespeichert wird,
- die Daten (D01-D2n) in die folgenden Sektoren (S2-Sn) des ersten Ersatzblockes (EB0, EB2) und einen weiteren Sektor (S1-Sn) eines zweiten Ersatzblockes (EB1) kopiert werden und
- in einer Einschaltphase einer Energieversorgung des Speichers (1) anhand des Status (St1, St2) überprüft wird, ob der Auftrag (A1, A2) beendet wurde, und bei nicht-beendetem Auftrag (A1, A2) der Kopiervorgang fortgesetzt wird.

2. Verfahren nach Anspruch 1,
wobei eine Zugehörigkeit zwischen einer logischen und einer physikalischen Speicheradresse in einer Spare-Area (4) eines jeden Sektors (S1-Sn) gespeichert wird.

3. NAND-Flash-Speicher (1) mit einer Vielzahl von Sektoren (S1-Sn), in die Daten (D01-D2n) ablegbar sind und die zu Blöcken (B0-B2, EB0-EB2) gruppiert sind, von denen eine vorgebbare Anzahl als Ersatzblöcke (EB0-EB2) vorgesehen sind, mit einer Energiespeicherung (2) und mit einem Treiber (3), mit dem ein Verfahren nach einem der Ansprüche 1 und 2 durchführbar ist.
